Europäisches Patentamt

(19) European Patent Office     (11) Publication number: **0 165 626**

Office européen des brevets     **B1**

(12) **EUROPEAN PATENT SPECIFICATION**

(45) Date of publication of patent specification: **29.11.89**     (51) Int. Cl.⁴: **H 01 L 23/48,** H 01 L 21/28

(21) Application number: **85200739.2**

(22) Date of filing: **10.05.85**

(54) **Method of manufacturing an electronic microcircuit provided with contact elevations.**

(30) Priority: **21.05.84 NL 8401619**

(43) Date of publication of application:
**27.12.85 Bulletin 85/52**

(45) Publication of the grant of the patent:
**29.11.89 Bulletin 89/48**

(84) Designated Contracting States:
**CH DE FR GB IT LI NL**

(56) References cited:
**EP-A-0 071 311**
**US-A-3 978 517**

(73) Proprietor: **N.V. Philips' Gloeilampenfabrieken**
**Groenewoudseweg 1**
**NL-5621 BA Eindhoven (NL)**

(72) Inventor: **Van de Pas, Hermanus Antonius**
**c/o INT. OCTROOIBUREAU B.V. Prof. Holstlaan 6**
**NL-5656 AA Eindhoven (NL)**
Inventor: **Vos, Hendrikus Johannes Maria**
**c/o INT. OCTROOIBUREAU B.V. Prof. Holstlaan 6**
**NL-5656 AA Eindhoven (NL)**
Inventor: **Wijburg, Matheus Adrianus Theresia**
**c/o INT. OCTROOIBUREAU B.V. Prof. Holstlaan 6**
**NL-5656 AA Eindhoven (NL)**

(74) Representative: **Houbiers, Ernest Emile Marie**
**Gerlach et al**
**INTERNATIONAAL OCTROOIBUREAU B.V. Prof.**
**Holstlaan 6**
**NL-5656 AA Eindhoven (NL)**

# Description

The invention relates to a method of manufacturing an eletronic microcircuit provided with contact elevations, in which method the contact elevations are mechanically formed at contact areas of the microcircuit by securing spherical parts melted from metal wire to the contact areas by means of a thermocompression treatment or an ultrasonic treatment.

Such method is known from Dutch Patent Application 8101371 published on October 28th 1982. This Patent Application describes a method of mechanically forming contact elevations (also designed as contact spheres or "bumps") on an electronic microcircuit, such as, for example, an integrated circuit. These contact elevations serve to establish electrical contact with conductors on a substrate or with conductors of a metal lead frame, in which event no connection wires need be used. The contact elevations can be obtained by melting one end of a wire to form a sphere and by pressing the sphere against a contact area on the microcircuit and thus connecting it to the contact area, after which the wire is severed at a weakened area near the sphere.

The mechanically provided contact elevations generally consist of gold. Although these gold bumps give satisfaction in a number of cases, they also have disadvantages in other cases. For example, the price is comparatively high. In connection with the required strength of the wire from which the sphere is melted the wire diameter will be at least 30 μm, and so the smallest diameter of the contact elevations is 60-80 μm. A smaller contact elevation would permit a larger number of contact areas to be obtained. Furthermore, a substrate provided with gold contact elevations should be secured to conductors of a carrier with great care. When the contact elevations are soldered to the conductors, the usual lead-tin solder will normally be used. The fact.should then be taken into account that gold is soluble in tin. Another securing technique, i.e. gluing, cannot readily be carried out with gold contact elevations.

It has also been suggested already to use other materials for contact elevations which are provided mechanically. For example, aluminium may be utilized. It is then not easy to melt the sphere. Also in this case, the diameter of the contact elevations will be comparatively large. Aluminium further has the disadvantage that it oxidizes rapidly so that the operation of securing the substrate with the contact elevations to conductors of a carrier meets difficulties.

It has further been suggested to use copper as material for the contact elevations. Besides the fact that with the use of copper contact elevations having a comparatively large diameter are again obtained, copper further has the disadvantage that it oxidizes. Moreover, the hardness of copper contact elevations is comparatively large so that the contact elevations should be provided on a substrate very carefully in order to prevent damage of the substrate.

The invention has for its object to provide a method of manufacturing an electronic microcircuit provided with contact elevations which are formed mechanically, in which the disadvantages described above will not occur. According to the invention, this object is achieved in that the material of which the contact elevations consist is palladium.

It is a surprise to find that contact elevations made of palladium have a number of advantages as compared with the usual materials. For example, the strength of a very thin palladium wire is sufficient to be able to obtain spherical parts having a small diameter. Moreover the price of palladium is very reasonable. The operation of soldering the palladium bumps to tin-plated conductors on a carrier does not give rise to problems because palladium is not soluble in tin. It has further been found that no problems arise when the contact elevations of palladium are glued to conductors on a carrier. The bumps of palladium do not oxidize and the hardness is not excessively large so that these bumps can be provided on a substrate without difficulty.

Preferably, the contact elevations consist of at least technically pure palladium, preferably palladium having a purity of 99.99%. Especially with very pure palladium, the great advantage of this material for contact elevations become clearly manifest.

A great advantage of palladium is that even with a thickness of about 12 μm a wire of this material is sufficiently strong to be used for the purpose. It is therefore possible to obtain from this wire contact elevations having a diameter of 30 μm, whereas in the case of gold this diameter is 60-80 μm. Consequently, a considerably larger number of contact elevations per unit length can be obtained.

Since the contact elevations can have a smaller diameter, a large number of connections for contact areas can be obtained. A particularly large number of connections can be obtained if the contact elevations are formed in a pattern near the circumference of the substrate and in one or more patterns located further inwards.

The invention will be described more fully with reference to the drawing. In the drawing:

Figure 1 shows a semiconductor element provided with a number of mechanically formed contact elevations;

Figure 2 shows a semiconductor element, in which the contact elevations are formed in two patterns.

It should be noted that for the sake of clarity the drawings are not to scale.

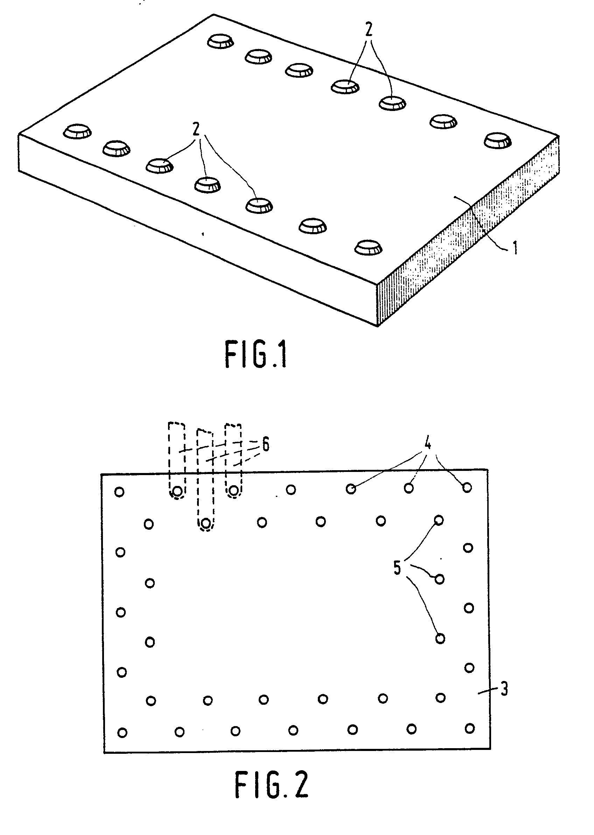

Figure 1 shows a semiconductor device, for example of silicon. In the element 1, a circuit, for example an integrated circuit, is formed by means of techniques usual in the manufacture of semiconductor devices. Contact areas are present on the semiconductor element 1. Contact elevations 2, also designated as "bumps", are provided at these contact areas. These contact elevations are formed from spherical parts which are fused from a metal wire and which are then secured on the semiconductor on the semiconductor element 1 by means of a thermocompression treatment or an ultrasonic treatment. The published Dutch Patent Application 8101371 describes an example of such a method of providing contact elevations. The contact elevations 2 serve as electrical connection points for the circuit in the semiconductor element 1.

According to the invention, the material of which the contact elevations consists is palladium. This material has the advantages which are extensively described above. Preferably, the contact elevations consist of technically pure palladium, preferably having a purity of 99.99%. One of the advantages of the use of palladium is, as stated above, that the diameter of the contact elevations can be small, i.e. about 30 μm, as a result of which a large number of contact elevations per unit length can be obtained.

Figure 2 shows the use of an even larger number of contact elevations on a semiconductor element 3. Contact elevations 4 of palladium are mechanically provided in an outer pattern on this semiconductor element, while contact elevations 5 of palladium are present in a pattern located further inwards. Moreover, a few connection conductors 6 are shown diagrammatically. These connection conductors may be provided, for example, on a foil of insulating material. They may alternatively be formed on a carrier substrate. The small diameter of the palladium contact elevations 4 and 5 permits a large number of electrical connections with the semiconductor element 3 to be obtained, whilst nevertheless the connection conductors can be connected in a comparatively simple manner to the contact elevations 4, 5.

## Claims

1. A method of manufacturing an electronic microcircuit provided with contact elevations, in which method the contact elevations are mechanically formed at contact areas of the microcircuit by securing spherical parts melted from a metal wire to the contact areas by means of a thermocompression treatment or an ultrasonic treatment, characterized in that the material of which the contact elevations consists is palladium.

2. A method as claimed in Claim 1, characterized in that the contact elevations consist of at least technically pure palladium, preferably palladium having a purity of 99.99%.

3. A method as claimed in Claim 1 or 2, characterized in that the contact elevations have a diameter of the order of 30 μm.

4. A method as claimed in any one of the preceding Claims, characterized in that the contact elevations are formed in a pattern near the circumference of the substrate and in one or more patterns located further inwards.

## Patentansprüche

1. Verfahren zum Herstellen einer elektronischen Mikroschaltung mit höckerförmigen Kontakten, wobei die höckerförmigen Kontakte auf mechanische Weise an den Kontaktstellen der Mikroschaltung dadurch gebildet werden, dass aus einem Metalldraht gesmolzene kugelförmige Teile durch eine Thermokompressionsbehandlung oder durch eine Ultraschallbehandlung an den Kontaktstellen befestigt werden, dadurch gekennzeichnet, dass das Material, aus dem die höckerförmigen Kontakte bestehen, Palladium ist.

2. Verfahren nach Anspruch 1, dadurch gekennzeichnet, dass die höckerförmigen Kontakte aus wenigstens technisch reinem Palladium, vorzugsweise palladium mit einer Reinheit von 99,99% bestehen.

3. Verfahren nach Anspruch 1 oder 2, dadurch gekennzeichnet, dass die höckerförmigen Kontakte einen Durchmesser in der Grössenordnung von 30 μm haben.

4. Verfahren nach einem der vorstehenden Ansprüche, dadurch gekennzeichnet, dass die höckerförmigen Kontakte in einem Muster in der Nähe des Umfangs des Substrats sowie in einem oder mehreren Mustern weiter einwärts liegend, gebildet sind.

## Revendications

1. Procédé de fabrication d'un micro-circuit électronique muni de protubérances de contact, selon lequel les protubérances de contact sont formées par voie mécanique aux plages de contact du microcircuit par fixation de parties sphériques obtenues par fusion d'un fil métallique aux plages de contact par un traitement de thermocompression ou un traitement ultrasonore, caractérisé en ce que le matériau dont sont réalisées les protubérances de contact est du palladium.

2. Procédé selon la revendication 1, caractérisé en ce que les protubérances de contact sont constituées par du palladium au moins techniquement pur, de préférence du palladium présentant une pureté de 99,99%.

3. Procédé selon la revendication 1 ou 2, caractérisé en ce que les protubérances de contact présentent un diamètre de l'ordre de 30 μm.

4. Procédé selon l'une des revendications précédentes, caractérisé en ce que les protubérances de contact sont formées dans une configuration près de la circonférence du substrat et dans une ou plusieurs configurations située(s) plus vers l'intérieur.

FIG.1

FIG.2